# EUROPÄISCHE PATENTANMELDUNG

(11) **EP 4 790 891 A1**
(43) Veröffentlichungstag der Anmeldung: **12.08.2026**
(21) Anmeldenummer: 25156653.5
(22) Anmeldetag: 07.02.2025
(51) Int. Cl.: H02S 40/30, H02S 40/32, H10F 77/00

(54) **SOLARZELLENANORDNUNG UND VERFAHREN ZUM BETRIEB EINER ENERGIEWANDLERANORDNUNG**

(71) Anmelder: Justenhoven, Barbara, 70563 Stuttgart-Vaihingen (DE)
(72) Erfinder: JUSTENHOVEN, Julius, 70563 Stuttgart-Vaihingen (DE)
(74) Vertreter: Ruckh, Rainer Gerhard

(57) **Zusammenfassung**

Die Erfindung betrifft eine Solarzellenanordnung mit einer Anordnung von Solarzellen (1). Die Solarzellen (1) werden in einem Arbeitspunkt mit negativem differenziellem Widerstand betrieben und die Solarzellen (1) werden mit Wechselstrom betrieben. Weiterhin betrifft die Erfindung ein Verfahren zum Betrieb einer Energiewandleranordnung.

## Beschreibung

Die Erfindung betrifft eine Solarzellenanordnung und ein Verfahren zum Betrieb einer Energiewandleranordnung.

Derartige Solarzellenanordnungen sind als regenerative Energiequellen in den letzten Jahren von steigender Bedeutung im Bereich der Energieversorgung und stellen zunehmend eine Alternative zur Energieerzeugung mit fossilen Energieträgern dar.

Derartige Solarzellen bestehen aus einer Mehrfachanordnung von Solarzellen, wobei vorteilhaft mehrere Solarzellen zu einem Solarmodul zusammengefasst sind und dementsprechend die Solarzellenanordnung eine Mehrfachanordnung von Solarmodulen aufweist.

Mit den Solarzellen der Solarzellenanordnung wird Licht in eine elektrische Spannung bzw. in einen Photostrom umgewandelt. Eine Solarzelle ist ein dotierter Halbleiter, entsprechend einer Photodiode, jedoch weist die Solarzelle eine erheblich größere lichtempfindliche Halbleiterfläche auf, um möglichst viel Sonnenlicht einzufangen.

Ein Nachteil bekannter Solarzellenanordnungen besteht im relativ geringen Wirkungsgrad der Solarzelle, da typischerweise nur etwa 13 bis 14 % der auftreffenden Strahlungsenergie des Sonnenlichts in nutzbare elektrische Energie gewandelt wird.

Die Verluste der Solarzellen beruhen zu einem geringen Anteil auf Reflexionsverlusten. Ein weit größerer Anteil von Verlusten beruht darauf, dass auftreffende Photonen nicht von der Solarzelle absorbiert werden sowie auf der nicht genutzten Überschussenergie der Photonen.

Der Erfindung liegt die Aufgabe zugrunde eine Solarzellenanordnung mit hohem Wirkungsgrad bereitzustellen.

Zur Lösung dieser Aufgabe sind die Merkmale der unabhängigen Ansprüche beschrieben. Vorteilhafte Ausführungsformen und zweckmäßige Weiterbildungen der Erfindung sind in den abhängigen Ansprüchen beschrieben.

Die Erfindung betrifft eine Solarzellenanordnung mit einer Anordnung von Solarzellen. Die Solarzellen werden in einem Arbeitspunkt mit negativem differenziellem Widerstand betrieben. Weiterhin werden die Solarzellen mit Wechselstrom betrieben.

Bei der erfindungsgemäßen Solarzellenanordnung ist der Wirkungsgrad zur Erzeugung elektrischer Energie aus Strahlungsenergie von Sonnenlicht gegenüber bekannten Solarzellenanordnungen signifikant erhöht.

Eine Voraussetzung hierfür ist, dass die Solarzellen in einem Arbeitspunkt betrieben werden, bei welchen die Solarzellen einen negativen differenziellen Widerstand aufweisen, so dass die Solarzelle in einem Energieabgabemodus, d.h. in einem Generatorbetrieb betrieben werden kann.

Erfindungsgemäß werden die Solarzellen der Solarzellenanordnungen mit Wechselstrom betrieben, wodurch sich die Solarzellenanordnungen von bekannten Anordnungen, die mit Gleichstrom bzw. Gleichspannung betrieben werden, unterschieden.

Damit erfolgt ein dynamischer Betrieb der einzelnen Solarzellen, mit welchem der Wirkungsgrad der Solarzelle gegenüber einem statischen Betrieb signifikant, insbesondere um mehr als 100 Prozent gesteigert werden kann.

Die Solarzellen stellen optische Halbleiterelemente dar, die im Wesentlichen Photodioden mit vergrößerten lichtempfindlichen Halbleiterelementen entsprechen.

Derartige Halbleiterelemente weisen in bekannter Weise ein Energieschema mit einem Valenzband und Leitungsband, getrennt durch ein Bandgap, in welchem die Energieniveaus von Donatoren bzw. Akzeptoren liegen, auf.

Voraussetzung für die Erzeugung von elektrischer Energie aus Sonnenlicht ist, dass die Energie von auftreffenden Photonen mit dem Bandgap der Solarzellen bzw. mit den Energieniveaus der Akzeptoren oder Donatoren übereinstimmt, so dass diese Photonen freie Ladungsträger in der Solarzelle generieren können. Die Photonen generieren dabei die freien Ladungsträger in der Raumladungszone der Solarzelle, die an den Kontakten der Solarzelle eine Spannung erzeugen. Wird ein Verbraucher an die Solarzelle angeschlossen, fließt durch diese ein elektrischer Strom.

Da bei der erfindungsgemäßen Solarzellenanordnung die Solarzellen mit Wechselstrom betrieben werden, wird durch diesen das Bandgap mit den Energieniveaus der Akzeptoren bzw. Donatoren moduliert.

Dadurch wird erreicht, dass die Energie der Photonen nicht mehr genau dem Bandgap der Solarzellen entspricht. Vielmehr werden die Energieniveaus der Solarzellen durch die Modulation der Wechselspannung verbreitert, so dass in einem erheblich erweiterten Energiebereich die Photonen freie Ladungsträger erzeugen können, wodurch die Photoströme der Solarzellen signifikant erhöht werden können. Dadurch werden Verluste bei der Umwandlung von Sonnenenergie in elektrische Energie in den Solarzellen erheblich reduziert, da Verluste aufgrund nicht absorbierter Photonen erheblich reduziert werden und auch Verluste aufgrund von Überschussenergien der Photonen, die nicht in elektrische Energie gewandelt werden können, erheblich reduziert werden.

Gemäß einer vorteilhaften Ausgestaltung ist die Periodendauer des Wechselstroms kleiner als die Rekombinationszeiten von Ladungsträgern in den Solarzellen.

Damit erfolgt mittels des Wechselstroms nicht nur eine Modulation und dadurch bedingt eine Verbreitung des Energieniveaus der Solarzellen. Vielmehr wird mit dieser Modulation auch ein dynamischer Effekt derart erzielt, dass eine vorzeitige Rekombination der Ladungsträger entgegenwirkt, was den Wirkungsgrad der Solarzellen weiter erhöht.

Gemäß einer vorteilhaften Ausführungsform der Erfindung, erfolgt der Betrieb der Solarzellen mit Wechselstrom dadurch, dass diese Solarzellen in einem Schwingkreis, vorteilhaft in einem Drehstrom-Resonator integriert sind.

Bei dem Schwingkreis, insbesondere dem Drehstrom-Resonator sind die Amplituden- und Phasenbedingung für einen Resonator erfüllt. Die Phasenbedingung besagt, dass die Phase des Resonators insgesamt 360° oder ein ganzzahliges Vielfaches davon beträgt. Die Amplituden-Bedingung des Resonators besagt, dass die Amplitude pro Umlauf ≥ 1 ist, d.h. es wird eine Verstärkung erzielt.

Die Photoströme der Solarzellen regen den Schwingkreis zu resonanten Schwingungen an, was zu einer Verstärkung der Photoströme der Solarzellen führt, wodurch der Wirkungsgrad der Solarzellen weiter erhöht wird.

Gemäß einer ersten Variante ist der Drehstrom-Resonator als Analog-Schaltung ausgebildet.

Vorteilhaft weist in diesem Fall der Drehstrom-Resonator nur Spulen und Kondensatoren als Schaltungselemente auf.

Der Resonator weist somit keine verlustbehafteten Widerstandelemente auf und hat demzufolge eine hohe Güte.

Gemäß einer zweiten Variante ist der Drehstrom-Resonator als Digital-Schaltung ausgebildet.

Die Solarzellen der Solarzellenanordnung können einzeln in den Schwingkreis integriert sein. Weiterhin kann die Solarzellenanordnung eine Anordnung von Solarmodulen umfassen, wobei jedes Solarmodul eine bestimmte Anzahl von Solarzellen aufweist. Dann können die einzelnen Solarmodule in dem Schwingkreis integriert sein.

Die Erfindung betrifft weiterhin ein Verfahren zum Betrieb einer Energiewandleranordnung mit einer Anordnung von Energiewandlerelementen, die ausgebildet sind eine Energieform in elektrische Energie zu wandeln. Die Energiewandlerelemente werden mit Wechselstrom betrieben.

Dabei werden die Energiewandlerelemente resonant in einem Resonator betrieben.

Bei dem erfindungsgemäßen Verfahren werden insbesondere in Schwingkreisen oder Resonatoren Energiewandlerelemente resonant mit Wechselstrom betrieben, um so mit hohem Wirkungsgrad spezifische Energieformen der Energiewandlerelemente in elektrische Energie umzuwandeln.

Die Energiewandlerelemente können Solarzellen sein, welche Lichtenergie in elektrische Energie wandeln.

Weiterhin können die Energiewandlerelemente Thermoelemente oder Peltier-Elemente sein, die Wärme in Elektrizität wandeln.

Weiterhin können die Energiewandlerelemente magneto-kalorische Elemente sein, die eine magnetische Kühlung bewirken und Wärme in Magnetismus wandeln.

Weiterhin können die Energiewandlerelemente elasto-kalorische Elemente sein, bei denen mechanische Verformungsenergie in Wärme umgesetzt wird, oder elektrokalorische Elemente, bei welchen Wärme in elektrische Energie gewandelt wird.

Schließlich können die Energiewandlerelemente von Wärme in Wärmestahlung umsetzenden Thermovoltaik-Elementen gebildet sein. Generell können auch weitere Energiewandlerelemente, die insbesondere Wärme in elektrische Energie wandeln, eingesetzt werden.

Die Erfindung wird im Folgenden anhand der Zeichnungen erläutert. Es zeigen
- Figur 1:: Beispiel einer Anordnung von Solarzellen der erfindungsgemäßen Solarzellenanordnung.
- Figur 2:: Diagramm von Verlusten von Solarzellen einer nach dem Stand der Technik arbeitenden Solarzellenanordnung.
- Figur 3:: Kennlinie einer Solarzelle.
- Figur 4:: Drehstrom-Resonator für die erfindungsgemäße Solarzellenanordnung in Form einer Analogschaltung.
- Figur 5:: Detaildarstellung des Kondensators C1 der Anordnung gemäß Figur 4.
- Figur 6:: Drehstrom-Resonator für die erfindungsgemäße Solarzellenanordnung in Form einer Digitalschaltung.
- Figur 7:: Detaildarstellung eines Elements des Drehstrom-Resonators gemäß Figur 6.

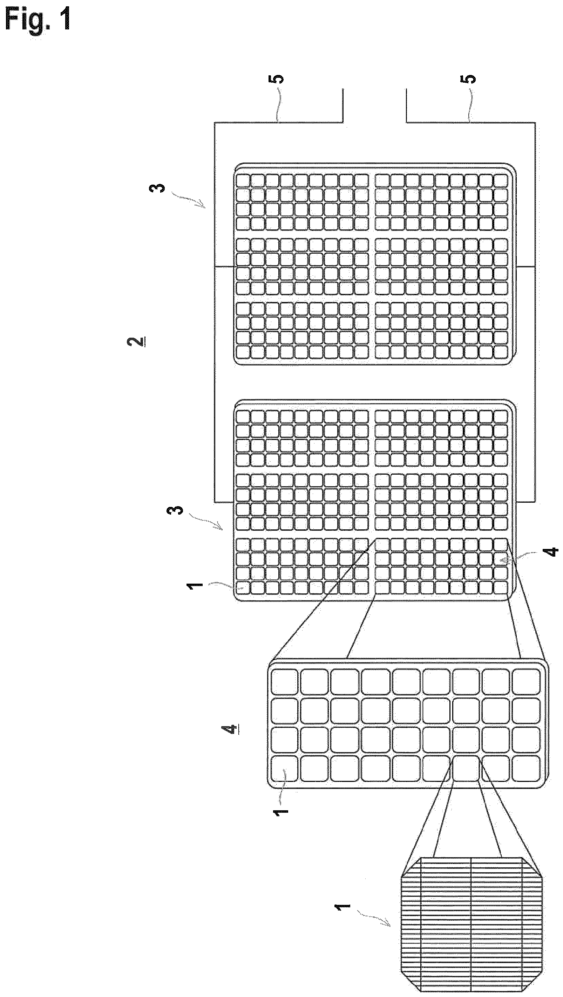

Figur 1 zeigt schematisch den Aufbau einer Anordnung von Solarzellen 1 für die erfindungsgemäße Solarzellenanordnung.

Die Anordnung gemäß Figur 1 bildet ein Solararray 2 mit mehreren Solarstrings 3. Jeder Solarstring besteht aus einer Mehrfachanordnung von Solarmodulen 4, wobei ein Solarmodul 4 separat abgesetzt in Figur 1 dargestellt ist.

Jedes Solarmodul 4 besteht aus einer Mehrfachanordnung von Solarzellen 1, wobei eine Solarzelle 1 separat abgesetzt in Figur 1 dargestellt ist.

Jedes Solarmodul 4 bildet vorteilhaft eine Baueinheit mit mehreren Solarzellen. Jeder Solarstring bildet vorteilhaft eine Baueinheit mit mehreren Solarmodulen 4.

In Figur 1 sind schematisch elektrische Anschlüsse 5 dargestellt. Diese werden bei der erfindungsgemäßen Solarzellenanordnung dazu genutzt, die Solarzellen 1 mit Wechselstrom zu betreiben.

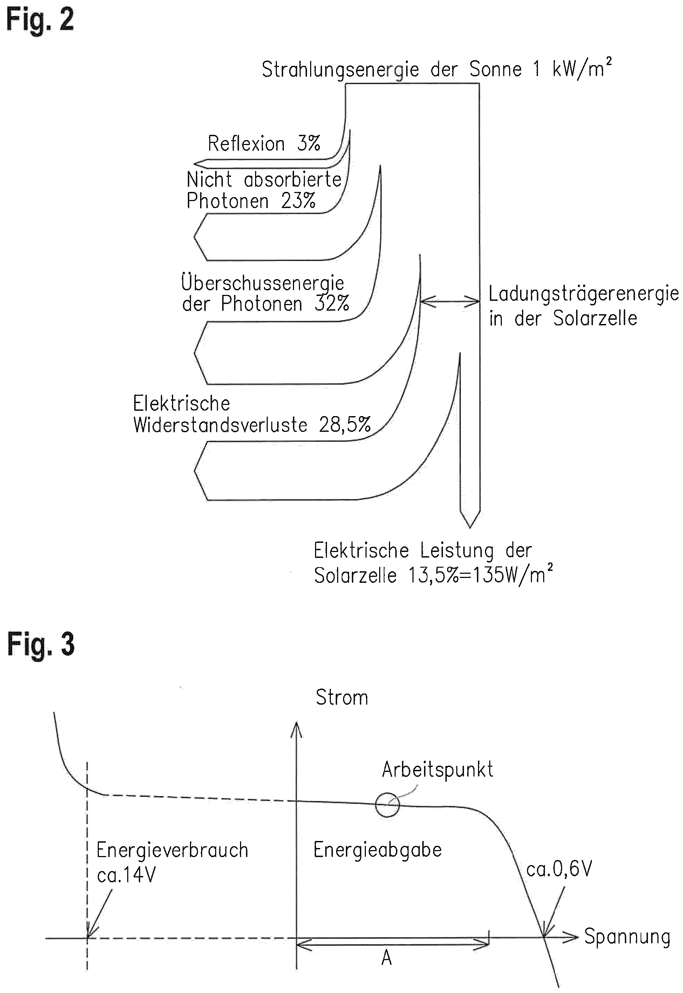

Figur 2 zeigt ein Diagramm der Verluste einer Solarzelle 1, die gemäß dem Stand der Technik mit Gleichspannung bzw. Gleichstrom betrieben wird.

Wie aus Figur 2 ersichtlich, werden nur 13,5 % der Strahlungsenergie der Sonne in nutzbare elektrische Leistung umgesetzt. Neben Verlusten durch Reflexionen an der Solarzelle 1 stellen nicht absorbierte Photonen, Überschussenergie der Photonen und elektrische Verluste die Hauptverlustquellen der Solarzellen 1 dar.

Figur 3 zeigt eine typische Kennlinie der Solarzelle 1, in welcher der Strom über die Spannung der Solarzelle 1 aufgetragen ist. Die Solarzelle 1 weist einen Bereich "Energieverbrauch" auf, in welchem die Solarzelle 1 Energie verbraucht.

Die Solarzelle 1 weist weiterhin einen Bereich "Energieabgabe" auf, in welchem die Solarzelle 1 Energie abgibt und einen Photostrom generiert.

Im Bereich Energieabgabe ist ein Bereich A vorhanden, der bei der erfindungsgemäßen Solarzellenanordnung für den Betrieb der Solarzellen 1 genutzt wird. Im Bereich A weist die Solarzelle 1 einen negativen differenziellen Widerstand auf.

In Figur 3 ist ein geeigneter Arbeitspunkt eingezeichnet, in dem die Solarzelle 1 vorzugsweise betrieben wird. Der Arbeitspunkt liegt etwa in der Mitte des Bereichs A.

Erfindungsgemäß werden die Solarzellen 1 der Solarzellenanordnung im Bereich des negativen differentiellen Widerstands betrieben und zudem mit Wechselstrom bzw. Wechselspannung betrieben.

Durch den Betrieb der Solarzellen 1 wird das Bandgap (d.h. die Energielücke zwischen Valenz- und Leitungsband) und das Energieniveau der Donatoren bzw. Akzeptoren im Bandgap moduliert.

Durch diese Modulation wird der Wirkungsgrad der Solarzellen 1 erheblich erhöht.

Bei aus dem Stand der Technik bekannten, mit Gleichstrom bzw. Gleichspannung betriebenen Solarzellen 1 sind das Bandgap, d.h. die Energielücke zwischen Leitungsband und Valenzband mit den diskreten Energieniveaus der Donatoren bzw. Akzeptoren konstant. Damit können nur Photonen, die genau diesen Energiedifferenzen entsprechen freie Ladungsträger in der Raumladungszone erzeugen, welche zum Photostrom der Solarzellen 1 beitragen. Durch den erfindungsgemäßen Betrieb der Solarzellen 1 mit Wechselstrom bzw. Wechselspannung wird durch die Modulation des Energienievaus ein vergrößerter Energiebereich der Photonen zur Generierung freier Ladungsträger geschaffen, wodurch ein größerer Photostrom in der Solarzelle 1 generiert wird, d.h. deren Wirkungsgrad wird vergrößert.

Der Betrieb der Solarzellen 1 der erfindungsgemäßen Solarzellenanordnung mit Wechselstrom erfolgt dadurch, dass die Solarzellen 1 in einem Schwingkreis, insbesondere Drehstrom-Resonator integriert sind, wobei Figur 1 schematisch die Anschlüsse 5 an den Schwingkreis zeigt.

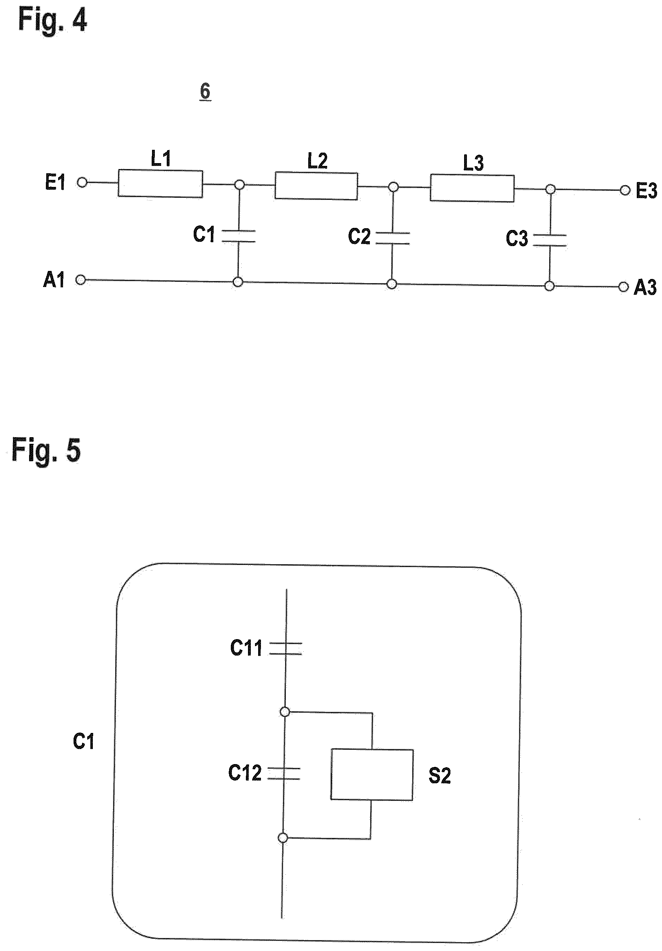

Figur 4 zeigt schematisch ein Beispiel eines derartigen Drehstrom-Resonators in Form eines Dreiphasen-Sinusgenerators 6.

Der Dreiphasen-Sinusgenerator 6 gemäß Figur 4 ist als Analog-Schaltung ausgebildet.

Der Dreiphasen-Sinusgenerator 6 weist eine Reihenanordnung von Schwingkreiselementen 7, nämlich Spulen L1, L2... und Kondensatoren C1, C2... auf, wobei jeweils eine Spule LN und ein Kondensator CN (N=1, 2...) eine Schwingkreiskomponente bilden. Natürlich können in der Reihenanordnung mehr als drei Paare von Spulen L1... und Kondensatoren C1... vorgesehen sein. Die Endpunkte E1 und E3 sowie die Endpunkte A1 und A3 der Reihenanordnung sind miteinander verbunden, so dass eine geschlossene Schwingkreisanordnung gebildet ist.

Figur 5 zeigt die Detailstruktur des Kondensators C1. Die weiteren Kondensatoren C2, C3... weisen eine hierzu identische Struktur auf.

Wie Figur 5 zeigt, besteht der Kondensator C1 aus einem oberen Kondensator C11 und einem unteren Kondensator C12, an welche eine Solarzelleneinheit S1 der Solarzellenanordnung angeschlossen ist. Die Solarzelleneinheit S1 kann von einer Solarzelle 1 oder einem Solarmodul 4 gebildet sein.

In diesem Drehstrom-Resonator sind die Amplituden- und Phasenbedingung für einen Schwingkreis derart erfüllt, dass die Phase des Drehstrom-Resonators exakt 360° oder ein ganzzahliges Vielfaches hiervon beträgt (Phasenbedingung), und dass die Amplitude pro Umlauf im Schwingkreis größer oder gleich 1 ist (Amplitudenbedingung).

Damit wird durch die Photoströme in den Solarzellen 1 der Schwingkreis zu ungedämpften Schwingungen angeregt, wodurch die Photoströme verstärkt werden. Die generierten Photoströme können von einem Verbraucher, insbesondere einem Motor genutzt werden.

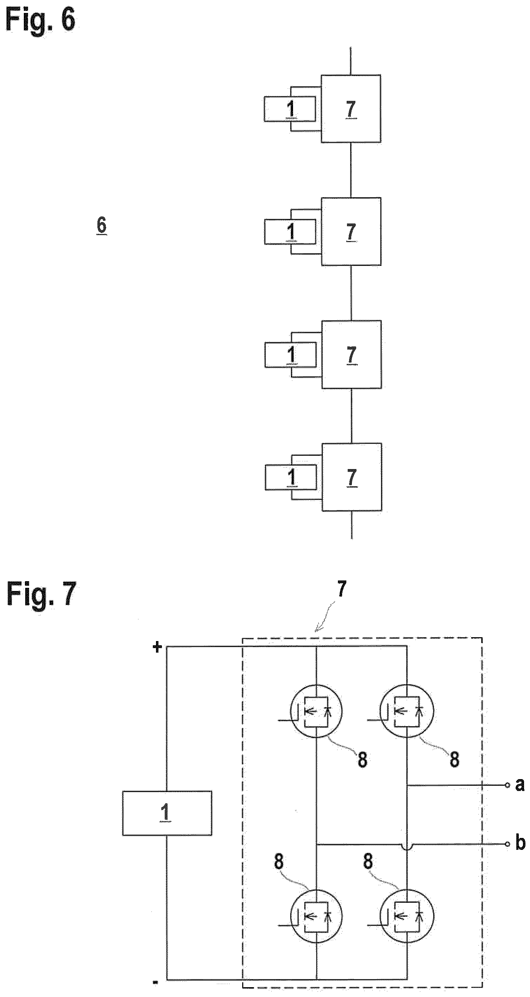

Figur 6 zeigt eine Variante eines Dreiphasen-Sinusgenerators 6, der in Form einer Digitalschaltung ausgebildet ist.

Der Dreiphasen-Sinusgenerator 6 ist in Form einer Reihenschaltung von identisch ausgebildeten Schwingkreiselementen 7 aufgebaut, die im vorliegenden Fall aus digitalen Bauelementen bestehen. Die einzelnen Schwingkreiselemente 7 sind über Anschlussleitungen a, b verbunden. Die Schwingkreiselemente 7 sind im vorliegenden Fall identisch ausgebildet.

An jedes Schwingelement ist eine Solarzelle 1 angeschlossen. Alternativ kann auch ein Solarmodul 4 angeschlossen sein.

Zur Bildung eines resonanzfähigen Schwingkreises ist die Anschlussleitung b des letzten Schaltkreiselements auf einen Eingang des ersten Schaltkreiselements geführt.

Figur 7 zeigt den Aufbau eines Schwingkreiselements 7 der Anordnung gemäß Figur 6. Das Schwingkreiselement 7 weist im vorliegenden Fall vier MOSFETs 8 auf.
Dr. Julius Justenhoven
71134 Aidlingen

### Bezugszeichenliste

- (1): Solarzelle
- (2): Solararray
- (3): Solarstrings
- (4): Solarmodul
- (5): Anschluss / Anschlüsse
- (6): Dreiphasen-Sinusgenerator
- (7): Schwingkreiselement
- (8): MOSFET

- (A): Bereich
- (a, b): Anschlussleitung
- (C1, C2, C3, CN): Kondensator
- (C11): obere Kondensator
- (C12): untere Kondensator
- (L1, L2, LN): Spule
- (S1): Solarzelleneinheit
- (A1): Endpunkt
- (A3): Endpunkt
- (E1): Endpunkt
- (E3): Endpunkt

## Patentansprüche

1. Solarzellenanordnung mit einer Anordnung von Solarzellen (1), **dadurch gekennzeichnet, dass** die Solarzellen (1) in einem Arbeitspunkt mit negativem differenziellem Widerstand betrieben werden, und dass die Solarzellen (1) mit Wechselstrom betrieben werden.

2. Solarzellenanordnung nach Anspruch 1, **dadurch gekennzeichnet, dass** die Solarzellen (1) in einem Schwingkreis (7) integriert sind.

3. Solarzellenanordnung nach einem der Ansprüche 1 oder 2, **dadurch gekennzeichnet, dass** die Solarzellen (1) in einem Drehstrom-Resonator integriert sind.

4. Solarzellenanordnung nach Anspruch 3, **dadurch gekennzeichnet, dass** der Drehstrom-Resonator als Analog-Schaltung ausgebildet ist.

5. Solarzellenanordnung nach Anspruch 4, **dadurch gekennzeichnet, dass** der Drehstrom-Resonator nur Spulen und Kondensatoren als Schaltungselemente aufweist.

6. Solarzellenanordnung nach Anspruch 3, **dadurch gekennzeichnet, dass** der Drehstrom-Resonator als Digital-Schaltung ausgebildet ist.

7. Solarzellenanordnung nach einem der Ansprüche 1 bis 6, **dadurch gekennzeichnet, dass** mittels des Wechselstroms eine Bandgap-Modulation der Solarzellen (1) durchgeführt wird.

8. Solarzellenanordnung nach einem der Ansprüche 1 bis 7, **dadurch gekennzeichnet, dass** die Periodendauer des Wechselstroms kleiner ist als die Rekombinationszeiten von Ladungsträgern in den Solarzellen (1).

9. Solarzellenanordnung nach einem der Ansprüche 1 bis 8, **dadurch gekennzeichnet, dass** Solarzellen (1) zu Solarmodulen (4) zusammengefasst sind.

10. Solarzellenanordnung nach Anspruch 9, **dadurch gekennzeichnet, dass** die Solarmodule (4) in den Schwingkreis integriert sind.

11. Verfahren zum Betrieb einer Energiewandleranordnung mit einer Anordnung von Energiewandlerelementen, die ausgebildet sind eine Energieform in elektrische Energie zu wandeln, **dadurch gekennzeichnet, dass** die Energiewandlerelemente mit Wechselstrom betrieben werden.

12. Verfahren nach Anspruch 11, **dadurch gekennzeichnet, dass** die Energiewandlerelemente resonant in einem Resonator betrieben werden.

13. Verfahren nach einem der Ansprüche 11 oder 12, **dadurch gekennzeichnet, dass** die Energiewandlerelemente Solarzellen (1) sind.

14. Verfahren nach einem der Ansprüche 11 oder 12, **dadurch gekennzeichnet, dass** die Energiewandlerelemente Thermoelemente oder Peltier-Elemente oder magneto-kalorische Elemente oder elasto-kalorische Elemente oder elektro-kalorische Elemente oder Thermovoltaik-Elemente sind.
